Europäisches Patentamt

European Patent Office

Office européen des brevets

(19)

(11) Publication number: **0 242 863 B1**

# EUROPEAN PATENT SPECIFICATION

(12)

(45) Date of publication of patent specification: **01.07.92**    (51) Int. Cl.⁵: **G03F  7/09**, G03C 1/72,
B41C 1/10

(21) Application number: **87105885.5**

(22) Date of filing: **22.04.87**

(54) **Process for manufacturing lithographic printing plates.**

(30) Priority: **23.04.86 JP 93531/86**

(43) Date of publication of application:
**28.10.87 Bulletin  87/44**

(45) Publication of the grant of the patent:
**01.07.92 Bulletin  92/27**

(84) Designated Contracting States:
**DE FR GB**

(56) References cited:
**EP-A- 0 109 838        EP-A- 0 220 943**
**WO-A- /85670           DE-A- 1 150 999**
**DE-A- 3 605 120        FR-A- 2 108 292**
**US-A- 3 219 446        US-A- 3 342 622**
**US-A- 4 399 209**

**PATENT ABSTRACTS OF JAPAN, vol. 8, no.
80 (M-289)[1517], 12th April 1984; & JP-A-58
224 752 (MITSUBISHI SEISHI K.K.) 27-12-1983**

**PATENT ABSTRACTS OF JAPAN, vol. 8, no.
87 (M-291)[1524], 20th April 1984; & JP-A-59
2845 (MITSUBISHI SEISHI K.K.) 09-01-1981**

**PATENT ABSTRACTS OF JAPAN, vol. 9, no.**

**29 (M-356)[1752], 7th Februar 1985; & JP-A-59
174 394 (MITSUBISHI) 02-10-1984**

(73) Proprietor: **FUJI PHOTO FILM CO., LTD.
210 Nakanuma Minami Ashigara-shi
Kanagawa 250-01(JP)**

(72) Inventor: **Hasegawa, Akira
No. 4000, Kawashiri Yoshida-cho
Haibara-gun Shizuoka-ken(JP)**

(74) Representative: **Patentanwälte Grünecker,
Kinkeldey, Stockmair & Partner
Maximilianstrasse 58
W-8000 München 22(DE)**

## Description

BACKGROUND OF THE INVENTION

Field of the Invention:

The present invention relates to a process for manufacturing a lithographic printing plate, in particular to a process for manufacturing a lithographic printing plate according to a dry processing.

Description of the Prior Art:

At the present time, a process for manufacturing lithographic printing plates, which is commonly utilised, comprises the steps of: coating an o-quinonediazide compound and a phenol resin, in the case of a positive-working lithographic printing plate, on a hydrophilic aluminum support which is previously grained to obtain a light-sensitive layer; subjecting the resulting light-sensitive layer to image-wise exposure in a desired pattern; dissolving out the exposed area of the light-sensitive layer with an alkaline developer; washing the developed product and then coating, for instance, a gum arabic layer thereon in order to prevent the reduction in the hydrophilic property of the surface of the aluminum support from which the light-sensitive layer is removed, such reduction in the hydrophilic property being observed when the surface is exposed to air.

In the foregoing process, it takes a long period of time even after the image-wise exposure in a desired pattern as well as a large space is required for placing a gum coater, storing the developer and the gum liquid, setting a sink or the like, besides that for installing an auto-developer. Moreover, a complex control is required to assure the remaining pattern having a constant area during development. Such control includes the precise adjustment of the temperature of a developer and the development time, the proper replenishment and exchange of the developer, or the like. In addition, there is a risk of causing environmental pollution associated with the disposal of the developer and a risk of causing an injury upon an operator during operation. Furthermore, it takes a great deal of time for washing the auto-developer and the gum coater and for the maintenance thereof.

As discussed above, there remain a variety of problems in the conventional process for producing a lithographic printing plate, in particular in the processes carried out after the image-wise exposure process.

Under such circumstances, there has been proposed a process for producing a lithographic printing plate which permits the formation of the pattern according to a very simple dry processing after the image-wise exposure procedure.

For example, U.S. Patent No. 3,374,049 discloses a process which comprises exposing an original plate for lithographic printing plate to light in a desired pattern, the original plate being obtained by applying, on a support, a layer of a hydrophilic binder in which (i) N-vinylamine, (ii) a halogenated hydrocarbon and (iii) a triaryl compound of P, Bi, Sb or As are dispersed, to make the exposed portion oleophilic; then heating the resulting product to evaporate and fix the polymerization initiator (ii). Moreover, U.S. Patent No. 3,505,37l discloses a process comprising exposing an original plate for lithographic printing plate to light in a desired pattern, the original plate being obtained by applying, on a support, a layer comprising (i) a vinyl resin, (ii) a polyene, a polythiol and a polymerization promotor; and then heating the exposed product to melt the resin thereby making the exposed portion oleophilic, while unexposed portion hydrophilic. In either of these processes, the oleophilic property of the exposed portion and the hydrophilic property of the unexposed portion are incomplete and, therefore, it is very difficult to obtain printed matters of high ink density and substantially free from background contamination.

In Japanese Patent Un-examined Publication No. 58-224753, there is disclosed a process comprising exposing an original plate for lithographic printing plate to light in a desired pattern, the original plate being prepared by applying, on a support of water resistance, a layer containing a photohardenable microcapsule in which a photohardenable resin is mainly included; pressing the exposed product; and again exposing the whole surface thereof to light to make the exposed portion oleophilic and the unexposed portion hydrophilic. In this process, a large-scaled presser is needed to collapse the microcapsule by applying a pressure. In this respect, the microcapsule can be collapsed only when the average diameter of the microcapsule is equal to or more than several micrometers. While if the diameter thereof is excessively large, resolution of the pattern is substantially reduced and further it may cause stains because of the collapse of the microcapsules during handling.

SUMMARY OF THE INVENTION

The inventors of this invention have conducted studies for eliminating the foregoing disadvantages associated with the conventional lithographic printing plates and as a result, the inventors have found that these disadvantages can effectively be eliminated by providing a microcapsule containing specific components and having a specific average diameter which makes it possible to form an oleophilic film, in some cases together with the component constituting the microcapsule wall, when it is heated and thus completed the present invention.

Accordingly, it is a principal object of this invention to provide a process for manufacturing a lithographic printing plate according to a simple dry processing, which surely provides a high resolution, image areas of high oleophilic property and non-image areas free from stains.

The aforementioned and other objects of the present invention can effectively be accomplished by providing a process according to claim 1.

## DETAILED EXPLANATION OF THE INVENTION

The process for producing lithographic printing plate according to the invention is based on the following fact that a uniform and oleophilic film can be obtained by heating the layer containing microapsules, in particular the un-exposed area, that is, a material constituting the microcapsule wall having heat softening properties and/or the contents of the microcapsule such as a photopolymerizable monomer, a light-sensitive resin are molten and admixed with each other to form such an oleophilic film during heating.

The microcapsules which can be used in the present invention and mainly contain a photopolymerizable monomer and/or a light-sensitive resin are those capable of controlling their thermal property with light. Although, the microcapsules are stable under usual conditions and during handling, they have a heat softening temperature and a heat permeation coefficient which vary depending upon the kind of materials used. Upon exposure to light, the microcapsules cause curing which leads to a substantial increase in the heat softening temperature thereof. When an original plate for lithographic printing comprising a support having, thereon, provided a microcapsule-containing layer of such properties is exposed to light emitted by, for example, metal halide lamp through a positive transparency having a desired pattern, the microcapsules present in the exposed area (non-image area) are cured and the heat softening temperature thereof is substantially increased, while those present in the un-exposed area (image area) do not cause any change in the heat softening temperature at all. Accordingly, if the original plate exposed to light is heated to a temperature not less than the heat softening point of the microcapsules which are not cured and not more than that of the microcapsules cured, only those present in the image area are softened and collapsed and the wall of the microcapsules and/or the contents thereof such as the photopolymerizable monomer, the light-sensitive resin or the like are admixed with each other to from a uniform and oleophilic film of ink receptivity. In this respect, it is also possible to apply a pressure by, for instance, passing the plate through a pair of rolls during heating for the purpose of easily causing admixing of the wall component of the microcapsules and/or the contents thereof such as the photopolymerizable monomer, the light-sensitive resin or the like. Moreover, although an image area having a sufficient strength and printing durability can be obtained by simply heating the exposed areas, whole surface of the exposed printing plate may additionally be exposed to light to enhance the film strength and the printing durability thereof.

According to the process of this invention, an image of uniform oleophilic film is obtained by heating an original plate for lithographic printing after exposing the same to light as explained above. This permits the substantial reduction in the average diameter of the microcapsules used compared with that of the microcapsules usually used in the conventional lithographic printing plate, which is collapsed by applying a pressure thereto and, therefore, the process of this invention makes it possible to produce a lithographic printing plate of a high resolution which in turn permits the faithful reproduction of details of patterns.

The term "polymerizable monomer" as used herein is defined as a compound having at least one member selected from the group consisting of vinyl and vinylidene groups, preferably a plurality of such groups and includes compounds having such group as acryloyl, methacryloyl, allyl, unsaturated polyester, vinyloxy or acrylamide. The most typical examples thereof are a reaction product of an unsaturated carboxylic acid with a polyol, a polyamine or an aminoalcohol and a reaction product of an acrylate or a methacrylate having hydroxyl group with a polyisocyanate.

Typical examples of such compounds include polyethylene glycol diacrylate, propylene glycol dimethacrylate, pentaerythritol triacrylate, trimethylolpropane diacrylate, trimethylolpropane triacrylate, pentaerythritol tetraacrylate, hexanediol diacrylate, l,2-butanediol diacrylate, tetrakis $\beta$-acryloxyethyl ethylenediamine, a reaction product of an epoxy resin with acrylic acid, a reaction product of methacrylic acid, pentaerythritol and acrylic acid, a condensation product of maleic acid, diethylene glycol and acrylic acid, methylmethacrylate, butylmethacrylate, styrene, divinylbenzene, diarylnaphthalene. The monomer used in the invention may be those disclosed in Japanese Patent Unexamined Publication Nos. 49-52889, 48-68641 and 48-32586, Japanese Patent Publication No. 49-7ll5 or the like. A plurality of these monomers may be used in combination according to intended purposes.

In general, these monomer absorb ultraviolet light of not more than 300 nm and, therefore, it is desirable to use a light-sensitive material together with the aforementioned monomers, which can absorbs light ranging from ultraviolet to visible light and is capable of causing polymerization of the monomers, for the purposes of imparting sensitivity to light of the aforementioned range to the microcapsules. Examples of such materials include those commonly known as polymerization initiators and have already been described, in detail, in a variety of articles such as "Light Sensitive Systems", Kosar, John Wiley & Sons; "Light Sensitive Resins". Warashina et al., Nikkan Kogyo Shinbunsha (Daily Industrial Newspaper Publishing Company); "Light Sensitive Resins", Printing Society, Kakuta et al.

Concrete examples of these photopolymerization initiators are aromatic ketones, quinone compounds, ether compounds and nitro compounds.

Typical examples thereof include benzoquinone, phenanthrenequinone, naphthoquinone, diisopropyl phenanthrenequinone, benzoisobutyl ether, benzoin, furoin butyl ether, Michler's ketone, Michler's thioketone, tetraphenylfuroin dimer, fluorenone, trinitrofluorenone and $\beta$-benzoyl-aminonaphtharene.

These initiators are added to the microcapsules alone or in combination in an amount of approximately from 0.l% to 30% on the basis of the vinyl compound.

In order to effectively carry out curing of the microcapsules by photopolymerization, it is possible to incorporate, into the microcapsules, a polymer such as those disclosed in Japanese Patent Application Serial No. 60-l5l864 and Japanese Patent Publication Nos. 46-327l4 and 49-3404l.

When preparing microcapsules from the foregoing polymerizable monomers, photopolymerization initiators, light-sensitive resins or the like, a solvent may be used simultaneously. The solvent includes, for example, natural or synthetic oils and these oils can be used independently or in combination. Examples of such oils are cotton oil, kerosine, aliphatic ketones, aliphatic esters, paraffin oil, naphthene oil, alkylated biphenyls, alkylated terphenyls, chlorinated paraffin oils, alkylated naphthalenes, and diarylethanes such as l-phenyl-l-xylylethane, l-phenyl-l-p-ethylphenylethane and l,l'-ditolylethane.

Moreover, as the light-sensitive resins, there may be mentioned, for instance, a cinnamate of polyvinyl alcohol, an azide compound and a cyclized rubber, or a light-sensitive resin of styrene-butadiene copolymer, diazo type light-sensitive resins, a light-sensitive resin composed of polyvinyl acetophenone and benzaldehyde.

Besides the foregoing components, a heat polymerization inhibitor may also be incorporated into the microcapsules of this invention. Useful examples thereof include hydroquinone, p-methoxyphenol, di-tert-butyl-p-cresol, pyrogallol, tert-butyl-catechol, benzoquinone, 4,4'-thiobis(3-methyl-6-tert-butylphenol), 2,2'-methylenebis(4-methyl-6-tert-butylphenol) and 2-mercaptobenzimidazole.

Moreover, it is also possible to incorporate, into the microcapsules, a dye or a pigment for the purposes of coloring the resulting light-sensitive layer, a pH indicator and dyes disclosed in Japanese Patent Un-examined Publication No. 60-l20345 as agents for obtaining a visible image immediately after image-wise exposure.

In order to dye the image areas of the light-sensitive layer, the microcapsules can further include color formers for photohardenable microcapsules and optionally developers which can produce a colored material when it comes into contact with a color former. The term "color former" as used herein means a compound having a property capable of developing a color by donating electrons to other compounds or accepting protons of, for instance, an acid. They are not restricted to a specific compound but it is common to use a compound which is usually colorless and has a partial skeleton such as lactone, lactum, sultone, spiropyran, ester, amide and causing ring opening or cleavage of these partial skeletons when it comes into contact with a developer. Concretely, the color former includes Crystal Violet lactone, benzoyl leuco Methylene Blue, Malachite Green lactone, rhodamine $\beta$-lactam, and l,3,3-trimethyl-6'-ethyl-8'-butoxyindorinobenzospiropyran.

The developer for these color former includes, for instance, a phenolic compound, an organic acid or a metal salt thereof, oxy ethyl benzoate and clays.

Among others, phenols or organic acids which are hardly soluble in water and have a melting point ranging from 50° to 250°C and in particular preferably 60° to 200°C.

Examples of the phenol compounds are 4,4'-isopropylidene-diphenol (bisphenol A), p-tert-butylphenol, 2,4-dinitrophenol, 3,4-dichlorophenol, 4,4'-methylene bis(2,6-di-tert-butylphenol), p-phenylphenol, 4,4-cyclohexylidene diphenol, 2,2'-methylene-bis(4-tert-butylphenol), 2,2'-methylenebis ($\alpha$-phenyl-p-cresol)-thiodiphenol, 4,4'-thiobis(6-tert-butyl-m-cresol), sulfonyl di-phenol, l,l-bis(4-hydroxyphenyl)-n-dodecane, ethyl 4.4-bis(4-hydroxyphenyl)-l-pentanoate, as well as p-tert-butylphenole - formalin condensate and p-phenylphenol - formalin condensate.

Useful examples of the oraganic acids include 3-tert-butyl-salicylic acid, 3,5-tert-butylsalicylic acid, 5-$\alpha$-methyl-benzyl-salicylic acid, 3,5-di-$\alpha$-methyl-benzylsalicylic acid, 3-tert-octylsalicylic acid, 5--α,γ-dimethyl-α-phenyl-γ-phenylpropylsali-cylic acid.

Examples of the oxy benzoates are ethyl p-oxy benzoate, butyl p-oxy benzoate, heptyl p-oxy benzoate, benzyl p-oxy benzoate.

In order to carry out effective mixing of the contents of the microcapsules during heating, a foaming agent can also be incorporated in the photohardenable microcapsules.

Such a foaming agent includes, for instance, nitroso type compounds, sulfohydrazido type compounds which are the hydrazine derivatives of organosulfonic acids, hydrazo type compounds and azo compounds.

Concrete examples of the organic foaming agents are dinitrosopentamethylenetetramine, N,N′-dimethyl-N,N′-dinitrosoterephthal-amide, trinitrosotrimethylenetriamine as the nitroso type compound.

Moreover, as the sulfohydrazide type compound, there may be mentioned, for instance, p-toluenesulfohydrazide, benzene-sulfohydrazide, p,p′-oxybis(benzenesulfohydrazide), benzene-l,3-disulfohydrazide, 3,3′-disulfohydrazide phenylsulfone, toluene-2,4-disulfohydrazide and p,p′-thiobis-(benzenesulfo-hydrazide).

Examples of the hydrazo compounds include hydrazodicarbamide, N,N′-dibenzoylhydrazine, β-acetylphenylhydrazine, biurea and l,l-diohenylhydrazine.

Examples of the azo compounds include azobisisobutyronitrile, azodicarbonamide (azobisformamide), diazoaminobenzene and diethyl azocarboxylate (diethyl azodicarboxylate).

All these organic foaming agents are decomposed upon heating and generates nitrogen gases. Although, some of them generate a small amount of carbon monoxide, carbon dioxide and water vapour other than nitrogen gas, at least 60% of all the gases generated is nitrogen gas. Moreover, the amount of the gas generated is approximately equal to l00 to 300 ml per gram of the foaming agent. The thermal decomposition temperature of these organic foaming agents fall within the range of from about 80° to 300°C. The foregoing organic foaming agents may be used alone or in combination and incorporated into the microcapsule in an amount of 0.l to 20% by weight based on the capsule.

In order to lower the decomposition temperature of the organic foaming agents, an auxiliary agent for thermal decomposition may also be used in the process of the present invention.

Effecitve examples of such auxiliary agents include urea and derivatives thereof, zinc white, lead carbonate, lead stearate and glycolic acid. Among them, particularly preferred are urea and the derivatives thereof such as urea ethanolamine, guanylurea and aminoguanidine carbonate. The amount of the auxiliary agents to be added is preferably in the range of about 30 to 60% by weight relative to that of the organic foaming agent.

For example, it is, in general, said that the decomposition temperature of a chemically pure azodicarbonamide is 230°C, however, this decomposition temperature can be lowered to about l20°C by the addition of different kinds of auxiliary agents for thermal decomposition.

The microcapsules as used in the present invention can be prepared according to any one of the processes known in the art. In this respect, reference is made to U.S. Patent Nos. 2,800,457 and 2,800,458 which disclose a process utilizing coacervation phenomenon of a hydrophilic wall-forming material; U.S. Patent No. 3,287,l54. British Patent No. 990,443 and Japanese Patent Publication Nos. 38-l9574, 42-446, and 42-7ll which disclose interfacial polymerization techniques for producing microcapsules; U.S. Patent Nos. 3,4l8,250 and 3,660,304 which disclose a process utilizing precipitaion of polymers; U.S. Patent No. 3,796,669 disclosing a process using an isocyanate polyol as the wall-forming material; U.S. Patent No. 3,9l4,5ll disclosing a process using an isocyanate as the wall-forming material; U.S. Patent Nos. 4,00l,l40; 4,087,376 and 4,089,802 which disclose a process using urea - formaldehyde type or ureaformaldehyde -resorcinol type wall-forming material; U.S. Patent No. 4,025,455 in which melamine-formaldehyde resin, hydroxypropyl cellulose or the like is used as wall-forming material; Japanese Patent Publication No. 36-9l63, Japanese Patent Un-examined Publication No. 5l-9079 which disclose an in situ technique for preparing microcapsules utilizing polymerization of monomers; British Patent Nos. 952,807 and 965,074 disclosing an electrolytic dispersion cooling process; and British Patent No. 930,422 and U.S. Patent No. 3,lll,407 disclosing a spray drying process. Although, it is not intended to restrict to a specific process, preferably a polymer film as the microcapsule wall is formed after the emulcification of core materials.

Concrete examples of the polymeric materials which constitute the microcapsule wall include polyurethane, polyurea, polyamide, polyester, polycarbonate, urea-formaldehyde resin, melamine resin, polystyrene, styrene-methacrylate copolymer, styrene-acrylate copolymer, gelatin, polyvinyl pyrrolidone, polyvinyl alcohol.

These polymeric materials may be used in combination. Preferred polymeric materials are, for example, polyurethane, polyurea, polyamide, polyester, and polycarbonate and particularly preferred are polyurethane and polyurea.

The average particle size of the microcapsules is desirably adjusted to not more than $30\mu$ and not

less than 0.0lμ. Particularly, in view of handling properties, the particle size is preferably not more than l0μ, while in view of resolution of patterns, it is particularly preferred to limit the particle size thereof to not more than 5μ.

In preparing the microcapsules, a water soluble polymer and a surfactant may be used. Such a water soluble polymer includes water soluble anionic polymers, nonionic polymers and amphoteric polymers. The anionic polymer may be natural or synthetic one and is, for example, those having -COO-, -SO₃- groups or the like. Concrete examples of the anionic natural polymer include gum arabic and alginic acid and semisynthetic product of such natural polymers are, for instance, carboxymethyl cellulose, phthalated gelatin, sulfated starch, sulfated cellulose and lignin sulfonic acid.

Examples of the water soluble synthetic polymers are anhydrous maleic copolymers (inclusive of hydrolizates thereof), acrylic (including methacrylic) polymers and copolymers, vinylbenzenesulfonic acid type polymers and copolymers, and carboxylated polyvinyl alcohols.

In addition, examples of the amphoteric water soluble polymers are gelatin.

As the surfactants which can be used in the present invention, there may be mentioned, for instance, nonionic surfactants such as polyoxyethylene alkyl ethers, polyoxyethylene alkyl phenyl ethers, polyoxyethylene fatty acid esters, sorbitan fatty acid esters, polyoxyethylene sorbitan fatty acid esters, glycerin fatty acid esters; anionic surfactants such as fatty acid salts, salts of alkylsulfates, alkylbenzenesulfonates, alkylnaphthalenesulfonates, salts of dialkylsulfosuccinates, salts of alkylphosphates, naphthalenesulfonic acid - formalin condensates, salts of polyoxyethylene alkylsulfates; cationic surfactants such as alkylamine salts, quaternary ammonium salts; polyoxyethylene alkylamine salts; and fluorinated surfactants. These dispersion stabilizing agents may be used independently or in combination.

As emulsifiers used for emulsifying and dispersing the foregoing components, those capable of imparting a great shearing force to a treated liquid or those capable of imparting a great shearing force to a treated liquid or those capable of applying very strong ultrasonic energy thereto may be used in the present invention. Preferred results can be expected if using a colloid mill, a homogenizer, a capillary type emulsifier, a liquid siren, an electromagnetostrictive type ultrasonic generator, and an emulsifier provided with a Pollmann whistle.

According to the process of this invention, the microcapsule thus prepared is then applied to the surface of a support. When applying the microcapsule to a support, a binder is in general used, which may be used alone or in combination. A hydrophilic binder is predominantly used and typical examples thereof are transparent or translucent hydrophilic binders which include natural materials such as gelatin, a derivative thereof, a cellulose derivative (for instance, carboxymethyl cellulose or methyl cellulose), a polysaccharide (for example, starch, gum arabic); and a synthetic polymeric material, for instance, a water soluble polyvinyl compound such as polyvinyl alcohol, polyvinyl pyrrolidone, acrylamide polymer, polyacrylic acid, vinyl acetate-acrylic acid copolymer.

The non-image areas of the lithographic printing plate obtained according to the process of this invention can be composed of either the hydrophilic microcapsule wall and/or hydrophilic binder or the hydrophilic surface of a support. A particularly excellent result can be expected if the non-image areas of the printing plate is constituted from portions of the layer containing microcapsules which are photohardened on a printing machine after applying the microcapsule and a hydrophilic binder to the surface of a support without strongly adhered thereto or the surface of the hydrophilic support which is exposed to air by removing a hydrophilic binder therefrom.

When the non-image areas of the printing plate is constituted from the hydrophilic capsule wall and/or the hydrophilic binder, the light-sensitive liquid for obtaining the light-sensitive layer may include a crosslinking agent such as melamine formaldehyde resin, urea formaldehyde resin, glyoxal or the like.

A support which can be used in the process of this invention includes paper; paper laminated with a plastic film such as polyethylene, polypropylene or polystyrene film; an aluminum (inclusive of alloys thereof) plate; a metal plate such as zinc, iron or copper plate; sheet or film of plastics such as cellulose acetate, cellulose propionate, cellulose butyrate, polyethylene terephthalate, polyethylene, polystyrene, polypropylene, polycarbonate and polyvinyl acetal; and paper or plastic film laminated with a metallic foil or deposited with a metal layer such as those listed above. The support may be subjected to surface roughening treatment, surface hydrophilizing treatment or the like according to need.

For example, an aluminum support is subjected to the following surface treatment. The aluminum suport is first grained according to an electrochemical graining method comprises dipping the support in an electrolyte such as hydrochloric acid or nitric acid and then supplying electric current therethrough; or a mechanical graining method such as a wire brush graining method which comprises scratching the surface of th aluminum with a metal wire, a ball graining method comprising graining the surface of the aluminum support with balls and an abrasive; a brush graining methd comprising rubbing the surface of the support with a nylon brush and an abrasive; or the like. The mechanical graining methods may be used alone or in combination.

The aluminum support thus treated is then subjected to a chemical etching treatment with an acid or an alkali. When an acid is used as the etching agent, it takes a long period of time to destroy fine structures of the surface thereof and thus the use of an acid is industrially unfavorable. However, such disadvantage can be eliminated by using an alkali as the etching agent. Examples of the alkali etching agents effectively used for this purpose include sodium hydroxide, sodium carbonate, sodium aluminate, sodium metasilicate, sodium phosphate, potassium hydroxide, lithium hydroxide, or the like and the etching treatment is preferably carried out at 20° to 100°C under the presence of an etching agent in an amount of 1 to 50% by weight so that 5 to 20 g/m² of aluminum is dissolved therein.

After the alkali etching, stains (smut) is in general formed on the surface of the treated support and thus the aluminum plate is desmutted with an acid. The acid used in the desmutting treatment includes nitric acid, sulfuric acid, phosphoric acid, chromic acid, hydrofluoric acid, borofluoric acid or the like.

When the aluminum support is treated according to electrochemical surface roughening method, the desmutting treatment is preferably effected according to a method comprising bringing the support into contact with 15 to 65% by weight of sulfuric acid having a temperature of 50° to 90°C (see Japanese Patent Un-examined Publication No. 53-12739); or an alkali etching method disclosed in Japanese Patent Publication No. 48-28123.

The aluminum plate thus treated can be used per se, however, the plate may further be subjected to anodization, formation treatment or the like according to need.

The anodization can be carried out in a manner conventionally used in the art. The anodization film can be formed on an aluminum plate by supplying alternating current or direct current in a nonaqueous or an aqueous solution containing at least one member selected from the group consisting of sulfuric acid, phosphoric acid, chromic acid, oxalic acid, sulfamic acid and benzenesulfonic acid.

The conditions for anodization vary depending upon the kind of electrolyte used and, in general, the anodization is desirably carried out under the conditions such that the concentration of the electrolyte is 1 to 80% by weight, the temperature thereof is 5° to 70°C, the current density is 0.5 to 60 A/dm², the electric voltage to be applied is 1 to 100 V, and the electrolysis time is 10 to 100 sec.

Among these anodization processes, preferred are those disclosed in British Patent No. 1,412,768 in which an aluminum plate is anodized under a high current density in an aqueous sulfuric acid and disclosed in U.S. Patent No. 3,511,661 in which the anodization is carried out in an aqueous phosphoric acid as electrolyte.

The aluminum plate thus roughened and anodized may further be subjected to a treatment such as those disclosed in U.S. Patent Nos. 2,714,066 and 3,181,461 in which the plate is treated with an aqueous solution of an alkali metal silicate such as sodium silicate by dipping the plate therein and an underlying layer of hydrophilic cellulose (e.g., carboxymethyl cellulose) containing a water soluble metal salt such as zinc acetate may be applied to the surface thereof as is disclosed in U.S. Patent No. 3,860,426.

Various kinds of fillers may also be added to the light-sensitive composition as used herein for the purposes of improving the adherence of the light-sensitive layer under vacuum during exposing images. Examples of such fillers include talc powder, glass powder, clay, starch, wheat powder, maize meal, polytetrafluoroethylene (Teflon) powder, and polyethylene powder.

Different kinds of additives, binders, antioxidants, dispersing agents, antifoaming agents, pigments, dyes, and surfactants conventionally used in the recording materials, as well as methods for applying microcapsules to supports and methods for using them are well known in the art and in this respect, reference is made to those disclosed in, for instance, U.S. Patent Nos. 2,711,375; 3,625,736; 3,836,383 and 3,846,331, British Patent No. 1,232,347, and Japanese Patent Un-examined Publication Nos. 50-44012; 50-50112; 50-127718 and 50-30515. Any one of them may be used in the present invention.

Moreover, a protective layer or a mat may also be applied to a surface of the original plate for lithographic printing for the purposes of controlling physical properties of the surface thereof.

The lithographic original plate produced according to the foregoing procedures is exposed to an actinic light followed by heating. Examples of the actinic light sources include mercury lamps, metal halide lamps, xenon lamps, chemical lamps, and carbon arc lamps. Moreover, a scanning exposure by a high density energy beam (e.g., laser beam or electron beam) may also be used in the present invention. Examples of such laser beam are He-Ne laser beam, Ar laser beam, Kr ion laser beam and He-Cd laser beam.

The microcapsule layer can be heated according to any methods such as a direct heating method, for instance, a method comprising heating the light-sensitive layer by coming the surface thereof into contact with rollers including heaters therein; a method comprising heating the layer by a heater such as ribbon heater, sheathed heater, infrared heater, or the like disposed around the surface thereof which is conveyed; a method comprising injecting hot air to the surface of the layer; a method in which the layer is dipped in or brought into contact with a hot liquid; or a self-heat generating method comprising irradiating electron beam, high frequency, or other electromagnetic waves.

The conditions of the heating such as heating temperature and time therefor vary depending on the kinds of the microcapsule wall-forming materials, thickness of the wall, the kinds of the contents of the capsule such as photopolymerizable monomers, light-sensitive resins or the like. Although, they are not restricted to a specific value, the effective temperature falls within the range of from 60° to 300°C, preferably 70° to 250°C and particularly preferred are 80° to 220°C. This is because, if the temperature is less than 60°C, it is difficult to obtain an oleophilic uniform film, while if it is more than 300°C, there is a strong tendency of forming stains.

Effective heating time falls within the range of from l/20 to 20 minutes, preferably l/l5 to l5 minutes and particularly preferred range thereof is l/l0 to l0 minutes.

After the exposure to light, the lithographic original plate can also be heated while applying a pressure. In such case, this procedure may be carried out by simply passing the plate through a couple of rollers including heaters therein, or by passing the plate through a pair of rollers disposed immediately behind the heating zone or within the heating zone. The magnitude of the pressure to be applied is not limited to a specific range, however, the use of a pressure of not more than about 500 kg/cm² is practically preferred in the present invention.

The lithographic printing plate of this invention may further be subjected to hydrophilization treatment of the non-image areas on the printing plate or oleophilization treatment of the image areas thereon, according to need, for the purposes of enhancing the printability thereof. A processing liquid used in the hydrophilization treatment generally includes those principally comprised of a hydrophilic resin, a phosphate, an aluminum alum compound and at least one of acids; or those mainly composed of a ferrocyanide and a ferricyanide. On the other hand, a processing liquid used in the oleophilization treatment includes those mainly comprised of a polymer having oleophilic groups in the molecules or the metal salts thereof.

The present invention will hereunder be described in more detail with reference to the following examples, however, it sould be appreciated that the present invention is not restricted to these specific examples.

Example I

(l) A support was produced according to the following procedures:

A substrate was first prepared according to a method similar to that disclosed in Japanese Patent Un-examined Publication No. 56-28893. In this process, the surface of an aluminum plate having a thickness of 0.24 mm was grained with a nylon brush and an aqueous suspension of pumice stone of 400 mesh followed by washing sufficiently. Then, the plate was dipped in l0% sodium hydroxide solution at 70°C for 60 seconds to etch the surface thereof, washed with running water, neutralized and washed with 20% HNO and further washed. The plate thus treated was subjected to an electrolytic surface roughening treatment in l% aqueous nitric acid under l60 coulomb/dm² in the quantity of electricity on the anode while using an alternating current of sine wave under the conditions such that the anode voltage is l2.7 V and the ratio of the quantity of anode time electricity to that of cathode time is 0.8. The surface roughness of the plate measured at this stage was 0.6 $\mu$ (expressed as Ra). Subsequently, the plate was immersed in 30% sulfuric acid at 55°C for 2 minutes to desmat and subjected to anodization in 20% sulfuric acid under the current density of 2 A/dm² so that the thickness thereof becomes 2.7 g/dm² Then, the plate was dipped in 2.5% aqueous solution of sodium silicate at 70°C for one minute, washed with water and dried.

(2) A light-sensitive liquid was then prepared by the following procedures:

There was dissolved 5 g of 2,2-dimethoxy-2-phenylacetophenone in 40 g of trimethylolpropane triacrylate and l0 g of TAKENATE DIION (manufactured and sold by TAKEDA PHARMACEUTICALS Co., Ltd.) was dissolved in and mixed with the resulting solution to obtain an oil phase of an intended emulsion.

The resultant oil phase was dispersed and emulsified in 50 g of 2% aqueous solution of polyvinyl alcohol PVA-205 (manufactured and sold by KURARAY CO., LTD.). To the emulsion, there was added 20 g of l.67% aqueous solution of diethylenetriamine while stirring at room temperature and the stirring was continued. After 30 minutes, the liquid was heated up to 40°C and the stirring was continued for additional one hour followed by cooling to form microcapsules. The average particle size of the resulting microcapsule was equal to 2.8$\mu$.

(3) There were added l00 g of water and l g of white dextrin (manufactured and sold by NICHIDEN CHEMICALS CO., LTD.) to 50 g of the microcapsule dispersion thus obtained to form and intended ligh-sensitive liquid. The light-sensitive dispersion was applied onto the foregoing aluminum support with a coating rod #l4 in an amount of 4.6 g/cm$^2$ (dry basis) and dried to obtain a lithographic original printing plate.

(4) The original printing plate was superposed with a positive transparency with vacuumization and exposed to light utilizing FT 26V UDNS ULTRA-PLUS FLIP-TOP PLATE MEKER (manufactured and sold by nuARC IND., INC.). Thereafter, the resultant plate was heated to l60°C for 2 minutes in an air-drying machine and thus a lithographic printing plate was obtained.

(5) The lithographic printing plate thus prepared was then set on a printing machine (HEIDELBERG G.T.O.) and the printing was effected to obtain printed matters having no background contamination and excellent in resolution.

Example 2

(l) A light-sensitive liquid was prepared according to the following procedures:

An oil phase of an intended emulsion was prepared by admixing 30 g of trimethylolpropane triacrylate, 3 g of 2,2-dimethoxy-2-phenylacetophenone, l5 g of BURNOCK DN 950 (manufactured and sold by DAINIPPON INK AND CHEMICALS INC.) and 20 g of ethylene dichloride. The oil phase was dispersed and emulsified in 2% aqueous solution of methyl cellulose. To the emulsion, there was added l0 g of l.67% aqueous solution of diethylenetriamine while stirring at room temperature and the stirring was continued. After 30 minutes, the liquid was heated up to 40°C and the stirring was further continued for additional 30 minutes followed by cooling to obtain microcapsules. The average particle size of the resulting microcapsules was 2.4$\mu$.

(2) The microcapsule dispersion thus prepared was then applied onto the aluminum support described in Example l in an amount of 4.2 g/m$^2$ (dry basis) and dried to obtain an original lithographic printing plate.

(3) The original printing plate was superposed with a positive transparency with vacuumization and exposed to light utilizing FT 26V UDNS ULTRA-PLUS FLIP-TOP PLATE MAKER (manufactured and sold by nuARC IND., INC.). Thereafter, the resultant plate was heated to l50°C for one minute in an air-drying machine followed by exposing whole the surface of the microcapsule layer to light and thus a lithographic printing plate was obtained.

(4) The lithographic printing plate thus prepared was then set on a printing machine (HEIDELBERG G.T.O.) and the printing was effected to obtain printed matters having no background contamination and excellent in resolution.

## Claims

1. A process for manufacturing a lithographic printing plate which comprises the steps of:
   applying on the hydrophilic surface of a support of said lithographic printing plate a layer comprising microcapsules, each comprising a photopolymerizable monomer and/or a light-sensitive resin and a hydrophilic wall for encapsulating,
   subjecting the applied layer to imagewise exposure to light, and then
   heating the exposed layer of the microcapsules for rupturing same whereby an ink-receptive oleophilic film is formed in light-unexposed areas of said lithographic printing plate.

2. The process as set forth in claim 1 wherein the average particle size of the microcapsule falls within the range of from 0.01 to 30 $\mu$m.

3. The process as set forth in claim 2 wherein the average particle size of the microcapsule is 0.01 to 10 $\mu$m.

4. The process as set forth in claim 2 wherein the average particle size of the microcapsule is 0.01 to 5 $\mu$m.

5. The process as set forth in claim 1 wherein the whole surface of the microcapsule layer is again exposed to light after heating the layer.

6. The process as set forth in claim 1, wherein said microcapsule-containing layer contains a binder.

7. The process as set forth in claim 6, wherein said binder is hydrophilic.

8. The process as set forth in claim 1 wherein the layer of the microcapsule after exposed to light is heated while pressing.

9. The process as set forth in claim 8 wherein the whole surface of the microcapsule layer is again exposed to light after heating and pressing.

**10.** The process as set forth in claim 1, wherein said photopolymerizable monomer is a compound having at least one vinyl or vinylidene group selected from the group consisting of an acryloyl group, methacryloyl group, allyl group, unsaturated polyester group, vinyloxy group and acrylamido group.

**11.** The process as set forth in claim 1, wherein said microcapsules contain a photopolymerization initiator capable of absorbing light at ultraviolet to visible region and initiating the polimerization of the photopolymerizable monomer.

**12.** The process as set forth in claim 1, wherein said microcapsules further contain a coloring agent.

**13.** The process as set forth in claim 12 , wherein said microcapsules further contain a color precursor.

**14.** The process as set forth in claim 1, wherein said microcapsules further contain an auxiliary agent for thermal decomposition.

**15.** The process as set forth in claim 1, wherein the wall of said microcapsules is made of at least one member selected from the group consisting of polyurethanes, polyureas, polyamides, polyesters, polycarbonates, urea-formaldehyde resins, melamine resins, polystyrene, styrenemethacrylate copolyers, styrene-acrylate copolymers, gelatin, polyvinyl pynolidone and polyvinyl alcohols.

**16.** The process as set forth in claim 15 , wherein said microcapsule wall is made of at least one member selected from the group consisting of polyurethanes, polyureas, polyamides, polyesters and polycarbonates.

**17.** The process as set forth in claim 16, wherein said microcapsule wall is made of at lest one member selected from the group consisting of polyurethanes and polyurea.

**18.** The process as set forth in claim 9 wherein the pressing operation is effected simultaneously with the heating operation.

**19.** The process as set forth in claim 9 wherein the pressing operation is carried out immediately after the heating operation.

**Revendications**

**1.** Un procédé pour fabriquer une plaque d'impression lithographique qui comprend les étapes suivantes :

on applique sur la surface hydrophile d'un support de ladite plaque d'impression lithographique une couche comprenant des microcapsules, comprenant chacune un monomère photopolymérisable et/ou une résine photosensible et une paroi hydrophile pour l'encapsulation,

on soumet la couche appliquée à l'exposition à la lumière suivant une image et ensuite

on chauffe la couche exposée des microcapsules pour les briser en formant ainsi un film oléophile recevant l'encre dans les zones non exposées à la lumière de ladite plaque d'impression lithographique.

**2.** Le procédé selon la revendication 1, caractérisé en ce que la dimension moyenne de particule des microcapsules est dans la gamme de 0,01 à 30 $\mu$m.

**3.** Le procédé selon la revendication 2, caractérisé en ce que la dimension moyenne des microcapsules est de 0,01 à 10 $\mu$m.

**4.** Le procédé selon la revendication 2, caractérisé en ce que la dimension moyenne des microcapsules est de 0,01 à 5 $\mu$m.

**5.** Le procédé selon la revendication 1, caractérisé en ce que l'on expose à nouveau toute la surface de la couche de microcapsules à la lumière après chauffage de la couche.

**6.** Le procédé selon la revendication 1, caractérisé en ce que ladite couche contenant les microcapsules contient un liant.

**7.** Le procédé selon la revendication 6, caractérisé en ce que ledit liant est hydrophile.

**8.** Le procédé selon la revendication 1, caractérisé en ce que la couche de microcapsules après exposition à la lumière est chauffée avec application de pression.

**9.** Le procédé selon la revendication 8, caractérisé en ce que toute la surface de la couche de microcapsules est à nouveau exposée à la lumière après chauffage et application de pression.

**10.** Le procédé selon la revendication 1, caractérisé en ce que ledit monomère photopolymérisable est un composé ayant au moins un groupe vinyle ou vinylidène choisi parmi un groupe acryloyle, un groupe méthacryloyle, un groupe allyle, un groupe polyester insaturé, un groupe vinyloxy et un groupe acrylamido.

11. Le procédé selon la revendication 1, caractérisé en ce que lesdites microcapsules contiennent un inducteur de photopolymérisation capable d'absorber la lumière dans la région de l'ultraviolet au visible et d'induire la polymérisation du monomère photopolymérisable.

12. Le procédé selon la revendication 1, caractérisé en ce que lesdites microcapsules contiennent en outre un agent colorant.

13. Le procédé selon la revendication 12, caractérisé en ce que lesdites microcapsules contiennent en outre un précurseur de couleur.

14. Le procédé selon la revendication 1, caractérisé en ce que lesdites microcapsules contiennent en outre un agent auxiliaire de décomposition thermique.

15. Le procédé selon la revendication 1, caractérisé en ce que la paroi desdites microcapsules est faite d'au moins un composé choisi parmi les polyuréthannes, les polyurées, les polyamides, les polyesters, les polycarbonates, les résines urée-formaldéhyde, les résines de mélamine, le polystyrène, les copolymères styrène-méthacrylate, les copolymères styrène-acrylate, la gélatine, la polyvinylpyrrolidone et les alcools polyvinyliques.

16. Le procédé selon la revendication 15, caractérisé en ce que ladite paroi de microcapsules est faite d'au moins un composé choisi parmi les polyuréthannes, les polyurées, les polyamides, les polyesters et les polycarbonates.

17. Le procédé selon la revendication 16, caractérisé en ce que ladite paroi de microcapsules est faite d'au moins un composé choisi parmi les polyuréthannes et les polyurées.

18. Le procédé selon la revendication 9, caractérisé en ce que l'opération d'application de pression est effectuée en même temps que l'opération de chauffage.

19. Le procédé selon la revendication 9, caractérisé en ce que l'opération d'application de pression est mise en oeuvre immédiatement après l'opération de chauffage.

## Patentansprüche

1. Verfahren zur Herstellung einer lithographischen Druckplatte, das die folgenden Schritte umfaßt:
Aufbringen einer Schicht, umfassend Mikrokapseln, die jeweils ein photopolymerisierbares Monomer und/oder ein lichtempfindliches Harz und eine hydrophile Wand zur Einkapselung umfassen, auf die hydrophile Oberfläche eines Trägers der lithographischen Druckplatte,
Unterwerfen der aufgebrachten Schicht einer bildweisen Belichtung, und anschließend
Erhitzen der belichteten Schicht der Mikrokapseln, um diese aufzubrechen, wobei ein für Tinte aufnahmefähiger oleophiler Film in den nicht belichteten Bereichen der lithographischen Druckplatte gebildet wird.

2. Verfahren nach Anspruch 1, worin die mittlere Teilchengröße der Mikrokapsel in dem Bereich von 0,01 bis 30 $\mu$m liegt.

3. Verfahren nach Anspruch 2, worin die mittlere Teilchengröße der Mikrokapsel 0,01 bis 10 $\mu$m beträgt.

4. Verfahren nach Anspruch 2, worin die mittlere Teilchengröße der Mikrokapsel 0,01 bis 5 $\mu$m beträgt.

5. Verfahren nach Anspruch 1, worin die gesamte Oberfläche der Mikrokapselschicht nach dem Erwärmen der Schicht nochmals belichtet wird.

6. Verfahren nach Anspruch 1, worin die Mikrokapseln enthaltende Schicht ein Bindemittel enthält.

7. Verfahren nach Anspruch 6, worin das Bindemittel hydrohphil ist.

8. Verfahren nach Anspruch 1, worin die Schicht der Mikrokapseln nach dem Belichten erwärmt wird, während Druck ausgeübt wird.

9. Verfahren nach Anspruch 8, worin die gesamte Oberfläche der Mikrokapselschicht nach dem Erwärmen und Druckausüben nochmals belichtet wird.

10. Verfahren nach Anspruch 1, worin das photopolymerisierbare Monomer eine Verbindung mit mindestens einer Vinyl- oder Vinylidengruppe ist, die gewählt ist aus der Gruppe, bestehend aus einer Acryloylgruppe, einer Methacryloylgruppe, einer Allylgruppe, einer ungesättigten Polyestergruppe, einer Vinyloxygruppe und einer Acrylamidogruppe.

11. Verfahren nach Anspruch 1, worin die Mikropkapseln einen Photopolymerisationsinitiator enthalten, der Licht von dem ultravioletten bis in den sichtbaren Bereich absorbieren und die Polymerisation des photopolymerisierbaren Monomers initiieren kann.

12. Verfahren nach Anspruch 1, worin die Mikrokapseln des weiteren ein färbendes Mittel enthalten.

13. Verfahren nach Anspruch 12, worin die Mikrokapseln des weiteren einen Farbvorläufer enthalten.

14. Verfahren nach Anspruch 1, worin die Mikrokapseln des weiteren ein Hilfsmittel für die thermische Zersetzung enthalten.

15. Verfahren nach Anspruch 1, worin die Wand der Mikrokapseln aus mindestens einer Verbindung, gewählt aus der Gruppe, bestehend aus Polyurethanen, Polyharnstoffen, Polyamiden, Polyestern, Polycarbonaten, Harnstoff-Formaldehyd-Harzen, Melminharzen, Polystyrol, Styrolmethacrylat-Copolymeren, Styrolacrylat-Copolymeren, Gelatine, Polyvinylpyrrolidon und Polyvinylalkoholen, hergestellt ist.

16. Verfahren nach Anspruch 15, worin die Mikrokapselwand aus mindestens einer Verbindung, gewählt aus der Gruppe, bestehend aus Polyurethanen, Polyharnstoffen, Polyamiden, Polyestern und Polycarbonaten, hergestellt ist.

17. Verfahren nach Anspruch 16, worin die Mikrokapselwand aus mindestens einer Verbindung, gewählt aus der Gruppe, bestehend aus Polyurethanen und Polyharnstoff, hergestellt ist.

18. Verfahren nach Anspruch 9, worin das Druckausüben gleichzeitig mit dem Erwärmen durchgeführt wird.

19. Verfahren nach Anspruch 9, worin das Druckausüben sofort nach dem Erwärmen durchgeführt wird.